# EUROPEAN PATENT APPLICATION

(11) **EP 2 664 937 A2**
(43) Date of publication of application: **20.11.2013**
(21) Application number: 13165502.9
(22) Date of filing: 26.04.2013
(51) Int. Cl.: G01R 31/36

(54) **Semiconductor device and voltage measuring device**

(30) Priority: 15.05.2012 JP 2012111212
(71) Applicant: Renesas Electronics Corporation, Kanagawa 211-8668 (JP)
(72) Inventor: Makino, Ryosei, Kanagawa 211-8668 (JP)
(74) Representative: Betten & Resch

(57) **Abstract**

In an assembled battery including plural cells series-coupled in multiple stages, each voltage measuring unit includes an analog front end unit which measures the voltages of cells, an interface unit for interfacing with a common bus, a voltage measurement control unit which controls the analog front end unit and the interface unit, and an insulating element which allows communication between the voltage measurement control unit and the interface unit in a state of being insulated from each other. The interface unit of each voltage measuring unit is electrically insulated, so that it can be coupled to a low-voltage power supply system of the electrical system that includes the battery system control unit. Since there is no potential difference between the interface unit and the battery system control unit, they can be coupled to each other via the common bus.

## Description

### CROSS-REFERENCE TO RELATED APPLICATIONS

The disclosure of Japanese Patent Application No. 2012-111212 filed on May 15, 2012 including the specification, drawings and abstract is incorporated herein by reference in its entirety.

### BACKGROUND

The present invention relates to a device for measuring the voltage generated by each of plural series-coupled voltage sources and collecting a measurement result and is suitably applicable, particularly, to a semiconductor device making up such a device.

At present, electric vehicles which each travel by being driven by a motor are being developed not only by automobile manufacturers but also by many other enterprises and organizations. Driving a motor for electric vehicle requires a vehicle-mounted high-voltage power supply capable of providing several hundred volts. Such a power supply is realized by a battery system made up of multiple series-coupled cells each capable of generating a voltage of about several volts. Such a battery system to be used under various conditions, for example, in a traveling vehicle or while being charged requires the voltage of each of the series-coupled cells to be measured with high accuracy so as to enable monitoring of the conditions (for example, over-charged condition, over-discharged condition, and battery level) of the battery system. If a battery system develops an abnormal condition, a serious incidence such as a fire or explosion may result. To operate a battery system safely, therefore, it is necessary to transmit data on the condition of the battery system such as the voltage of each of the plural cells measured by a voltage measuring device to a system control device to have the data checked in real time and to appropriately control the battery system based on the data.

If a person touches an assembled battery having a high voltage, he or she may be seriously injured by electrification. It is, therefore, necessary to electrically insulate parts such as an assembled battery for electric vehicle, the motor coupled with the assembled battery via a conductive wire, and the inverter circuit to drive the motor from a vehicle's low-voltage electrical system which includes parts operating in a state of being coupled to the vehicle body used as a common reference potential. Of the plural voltage measuring units included in a voltage measuring device to measure the voltages of the plural cells, respectively, those to measure the voltages of cells on the high potential side of the assembled battery are several hundred volts higher in potential than the low-potential electrical system. Hence, the control signals to be sent from the system control device to the voltage measuring device and the signals representing battery voltage data collected by the voltage measuring device and to be transmitted from the voltage measuring device to the system control device are required to be electrically insulated.

In a related-art configuration proposed for data transmission in a battery system, a system control device and plural voltage measuring units are coupled, on a one-to-one basis, via communication paths each provided with an insulating element such as a photocoupler for electric insulation.

In Japanese Unexamined Patent Publication No. Hei 11 (1999)-196537, an assembled battery system is disclosed which includes plural cells series-coupled in multiple stages. In the assembled battery system, plural battery modules each measure the voltages of plural cells individually and are each coupled through a bus and via an insulating element to a microcomputer for system control. Each of the battery modules is provided with a voltage detector for measuring the voltages of plural cells individually and a microcomputer coupled to the voltage detector. The voltages of cells individually measured by each battery module are transmitted to the microcomputer for system control through a bus and via an insulating element. The microcomputer for system control is provided with as many communication ports as the number of battery modules to be coupled thereto. The battery modules are coupled to the communication ports on a one-to-one basis through the buses (so referred to in the patent document). The battery modules measure the voltages of the plural cells series-coupled in multiple stages, so that they mutually differ in potential. Battery modules on the high potential side reach several hundred volts in potential. The microcomputer for system control on the other hand is disposed on the low voltage side with a potential close to that of the vehicle body. Hence, the buses are each electrically insulated using an insulating element such as a photocoupler.

In Japanese Unexamined Patent Publication No. 2003-70179, a battery system is disclosed in which, instead of coupling all battery modules and a microcomputer for system control on a one-to-one basis through buses each insulated using an insulating element, only some battery modules are coupled to the microcomputer for system control on a one-to-one basis with the other battery modules respectively coupled to adjacent ones without being insulated. The battery modules coupled to adjacent ones mutually differ in potential, but the potential difference between any two adjacent battery modules is not large, so that information represented by electric current is transmitted between them involving no insulating element. In this way, the number of communication paths insulated using insulating elements can be reduced for cost reduction. The communication paths with insulating elements (though not referred to as buses) referred to in Japanese Unexamined Patent Publication No. 2003-70179 have functions similar to those of the buses referred to in Japanese Unexamined Patent Publication No. Hei 11 (1999)-196537.

In Japanese Unexamined Patent Publication No. 2008-131670, an assembled battery system is disclosed which includes plural cells series-coupled in multiple stages. In the assembled battery system, plural intelligent detection modules each being for measuring the voltages of plural cells individually are each serially coupled, on a one-to-one basis, via an insulating element to a multiplexer coupled to a central microcomputer. In this configuration, the system is controlled in a decentralized manner by the intelligent detection modules and the central microcomputer. The intelligent detection modules are coupled to the cells series-coupled in multiple stages with the intelligent detection modules corresponding to the multiple stages, causing the intelligent detection modules to mutually differ in potential. Though the intelligent detection modules are coupled to the central microcomputer via the multiplexer, they communicate with the central microcomputer basically on a one-to-one basis.

### SUMMARY

The assembled batteries disclosed in the above related-art patent documents are each comprised of cells series-coupled in multiple stages and, in each of the assembled batteries, plural battery voltage measuring units each being for measuring the voltages of individual cells are coupled to a microcomputer for system control on a one-to-one basis. When the number of stages of series-coupled cells is increased to have a higher voltage generated by the assembled battery, it is necessary to proportionally increase the number communication paths for coupling between plural battery voltage measuring units and a microcomputer for system control. Increasing the number of communication paths, however, requires the number of communication ports of the microcomputer for system control to be increased by the same number while the volume of wire harness to make up communication paths also increases. This inevitably increases the system cost.

Means for solving the above problem will be described in the following. Other objects and novel features of the present invention will become apparent from the following description and the attached drawings.

An embodiment of the present invention is as follows.

In an assembled battery comprised of plural cells series-coupled in multiple stages, plural voltage measuring units each being for measuring the voltages of individual cells and a battery system control unit are coupled via a common bus. Each of the voltage measuring units is comprised of an analog front end unit for measuring the voltages of individual cells, an interface unit for interfacing between the voltage measuring unit and the common bus, a voltage measurement control unit for controlling the analog front end unit and the interface unit, and an insulating element for allowing communication between the voltage measurement control unit and the interface unit in an electrically insulated state.

Effects of the above embodiment are briefly described below.

The interface unit of each of the plural voltage measuring units is electrically insulated, so that it can be coupled to a low-voltage power supply system of the electrical system that includes the battery system control unit. Since there is no potential difference between the interface unit and the battery system control unit, they can be coupled to each other via a common bus. With the plural voltage measuring units and the battery system control unit coupled via the common bus, the battery system control unit requires no communication port other than that for interfacing with the common bus and, also, no communication wire harness is required other than the common bus. This keeps the system cost low.

### BRIEF DESCRIPTION OF THE DRAWINGS

FIG. 1 is a block diagram of an assembled-battery voltage measuring device according to a first embodiment of the present invention.
FIG. 2 is a block diagram of an assembled-battery voltage measuring device according to a second embodiment of the present invention.
FIG. 3 is a block diagram of an assembled-battery voltage measuring device according to an embodiment of means for solving problems.
FIG. 4 is a block diagram showing an embodiment of an interface unit 6.
FIG. 5 is a block diagram showing an interface unit 6 and insulator circuit 8 according to a fourth embodiment of the present invention.
FIG. 6 is a flowchart of a power restoring control sequence according to the fourth embodiment of the present invention.
FIG. 7 is a bird' s-eye view of a voltage measuring unit mounted according to a fifth embodiment of the present invention.
FIG. 8 is a block diagram showing an application of a voltage measuring device.

### DETAILED DESCRIPTION

### 1. Outline of Embodiment

First, a typical embodiment disclosed in the present application will be outlined below. Note that the reference numerals used in attached drawings and referred to, in parentheses, in the following outline description of the typical embodiment of the present invention merely denote exemplary constituent elements included in the concepts of possible constituent elements.

### [1] <Common bus + transceiver + insulator + voltage measurement control unit>

A semiconductor device is for measuring a voltage of each of plural cells (B11 to Bmn) which are series-coupled in multiple stages making up an assembled battery and for transmitting a measurement result to a battery system control unit (1) via a common bus (9).

The semiconductor device includes an analog front end unit (4) which measures the voltage of each of the cells and a voltage measurement control unit (5) which performs control to transmit a measurement result outputted from the analog front end unit to the common bus. The semiconductor device further includes an interface unit (6) which can make switching between driving the common bus and setting a coupling thereof with the common bus to high impedance and an insulating element (8) which allows communication between the voltage measurement control unit and the interface unit in a state of being electrically insulated from each other.

In the above semiconductor device, the battery system control unit (1) requires no communication port other than that for interfacing with the common bus (9) and, also, no communication wire harness is required other than the common bus (9). This keeps the system cost low. Since the analog front end unit (4) and the voltage measurement control unit (5) are both disposed on the battery side with respect to the insulator circuit (8) (may hereinafter be referred to simply as the "battery side") and are included in a same power supply system, the power consumption can be reduced by various methods.

### [2] <Regulator>

The semiconductor device described in [1] above further includes a regulator (7) which stabilizes power supplied from the cells and supplies the power to the voltage measurement control unit. The regulator has a power supply control signal (10) for supplying and stopping the power to the voltage measurement control unit.

In the semiconductor device described in [2] above, voltage measurement can be performed without being affected by noise, for example, variations in the load on the battery. Also, power supply to the analog front end unit (4), voltage measurement control unit (5) and insulator circuit (8) can be controlled either individually or collectively. This makes it possible to reduce the power consumption of the voltage measurement control unit (2).

### [3] <Power supply/shut-off control>

In the semiconductor device described in [2] above, the power supply control signal is controlled based on a receive signal (30) outputted from the interface unit.

In the semiconductor device described in [3] above, supplying and shutting off power supply for individual voltage measuring units (2_1 to 2_m) can be controlled based on control commands transmitted by the battery system control unit (1) via the common bus (9). Hence, it is possible, while keeping the system cost low by adopting the common bus and reducing the wire harness required, to reduce the system power consumption.

### [4] <Power restoration>

The semiconductor device described in [3] above further includes a power restoration control circuit (41), an inductively coupled insulating element (46) and a peak detection circuit (47). The power restoration control circuit starts outputting a first AC signal based on the receive signal. The inductively coupled insulating element converts the first AC signal in a state of being insulated DC-wise into a second AC signal and transmits the second AC signal to the peak detection circuit. The peak detection circuit controls the power supply control signal using the second AC signal after rectifying and smoothing the second AC signal.

In the semiconductor device described in [4] above, the power supply to the battery side that has been shut off can be restored using a control command transmitted via the common bus (9).

### [5] <Differential bus>

The semiconductor device described in [1] above further includes a power supply terminal (VCC) on a low voltage side for supplying power to the interface unit. The interface unit has a differential drive circuit (including 23 and 25 to 28) and a differential reception circuit (24). The differential drive circuit operates using power supplied from the power supply terminal on the low voltage side and either drives the common bus using a differential signal or outputs high impedance. The differential reception circuit operates using the power supplied from the power supply terminal on the low voltage side and receives the differential signal from the common bus.

In the semiconductor device described in [5] above, the noise immunity of the common bus (9) is enhanced.

### [6] <CAN (Controller Area Network)>

In the semiconductor device described in [5] above, the differential drive circuit drives the common bus in a manner to meet a CAN standard, and the differential reception circuit receives a signal from the common bus meeting the CAN standard.

In the semiconductor device described in [6] above, communication reliability can be further improved. This is because the CAN (Controller Area Network) specifies a communication data configuration in which bit errors and burst errors, if contained in communication data, can be detected and corrected.

### [7] <SiP (System in Package)>

In the semiconductor device described in [1] above, the analog front end unit, the voltage measurement control unit, the interface unit, and the insulating element are integrated in a same package.

The semiconductor device described in [7] above makes it possible to reduce the system cost by making components smaller and also to reduce the area required for mounting the substrate.

### [8] <Micro-isolator>

In the semiconductor device described in [7] above, the insulating element is a transformer formed over a semiconductor substrate with a primary side and a secondary side of the transformer insulated from each other across an insulating layer and with the voltage measurement control unit also formed over the semiconductor substrate.

The semiconductor device described in [8] above makes it possible to reduce the system cost by making components smaller and also to reduce the area required for mounting the substrate.

### [9] <SOI (Silicon On Insulator)>

In the semiconductor device described in [7] above, the insulating element is a transformer formed over a semiconductor substrate with a primary side and a secondary side of the transformer insulated from each other across an insulating layer. Also, the voltage measurement control unit, the insulating element, and the interface unit are formed over a same SOI substrate, the voltage measurement control unit and the interface unit being formed over wells insulated from each other.

The semiconductor device described in [9] above makes it possible to reduce the system cost by making components smaller and also to reduce the area required for mounting the substrate.

### [10] <Voltage measuring device (assembled battery + voltage measuring units + common bus + battery system control unit)>

A voltage measuring device includes plural voltage measuring units (2_1 to 2_m) corresponding to plural cell groups (B11 to B1n, B21 to B2n, - - - Bm1 to Bmn) making up an assembled battery by being series-coupled in multiple stages, a common bus (9) intercoupling the voltage measuring units, and a battery system control unit (1) coupled to the common bus.

The voltage measuring units each include an analog front end unit (4) which measures the voltage of each cell included in a corresponding one of the cell groups and a voltage measurement control unit (5) which performs control to transmit a measurement result outputted from the analog front end unit to the common bus. The voltage measuring units each further include an interface unit (6) which can make switching between driving the common bus and setting a coupling thereof with the common bus to high impedance and an insulating element (8) which allows communication between the voltage measurement control unit and the interface unit in a state of being electrically insulated from each other.

In the voltage measuring device described in [10] above, the battery system control unit (1) transmits control commands to plural voltage measuring units (2_1 to 2_m) via the common bus (9). Each of the voltage measuring units (2_1 to 2_m) controls the corresponding analog front end unit (4) based on the control command received, measures the voltages of plural cells of the corresponding battery group, and transmits the measurements to the battery system control unit (1) via the common bus.

### [11] <Regulator>

In the voltage measuring device described in [10] above, the voltage measuring units each further include a regulator (7) which stabilizes power supplied from a corresponding one of the cell groups and supplies the power to the voltage measurement control unit. The regulator supplies and stops the power to the voltage measurement control unit according to a power supply control signal (10).

In the voltage measuring device described in [11] above, voltage measurement can be performed without being affected by noise, for example, variations in the load on the battery. Also, power supply to the analog front end unit (4), voltage measurement control unit (5) and insulator circuit (8) can be controlled either individually or collectively. This makes it possible to reduce the power consumption of the voltage measurement control unit (2).

### [12] <Power supply/shut-off control>

In the voltage measuring device described in [11] above, the voltage measuring units each control the power supply control signal according to a control command issued by the battery system control unit via the common bus.

In the voltage measuring device described in [12] above, supplying and shutting off power supply for individual voltage measuring units (2_1 to 2_m) can be controlled based on control commands transmitted by the battery system control unit (1) via the common bus (9). Hence, it is possible, while keeping the system cost low by adopting the common bus and reducing the wire harness required, to reduce the system power consumption.

### [13] <Power restoration>

In the voltage measuring device described in [12] above, the voltage measurement control unit can output, based on the control command, a signal for stopping power supply to the voltage measurement control unit as the power supply control signal. The voltage measuring units each further include a power restoration control circuit (41), an inductively coupled insulating element (46), and a peak detection circuit (47). The power restoration control circuit starts outputting a first AC signal based on the control command. The inductively coupled insulating element converts the first AC signal in a state of being insulated DC-wise into a second AC signal and transmits the second AC signal to the peak detection circuit. The peak detection circuit is capable of outputting a signal generated by rectifying and smoothing the second AC signal as the power supply control signal for causing power supply to the voltage measurement control unit to be started.

In the voltage measuring device described in [13] above, the power supply to the battery side that has been shut off can be restored using a control command transmitted via the common bus (9).

### [14] <Differential bus>

In the voltage measuring device described in [10] above, the voltage measuring units each further include a regulator (7) which stabilizes power supplied from a corresponding one of the cell groups and supplies the power to the voltage measurement control unit.

The interface unit is supplied with constant-voltage power with which the battery system control unit is also supplied. The interface unit has a differential drive circuit (including 23 and 25 to 28) and a differential reception circuit (24). The differential drive circuit operates using power supplied on the low voltage side and either drives the common bus using a differential signal or outputs high impedance. The differential reception circuit operates using power supplied on the low voltage side and receives a differential signal from the common bus.

In the voltage measuring device described in [14] above, the noise immunity of the common bus (9) is enhanced.

### [15] <CAN (Controller Area Network)>

In the voltage measuring device described in [14] above, the network including the common bus meets a CAN standard.

In the voltage measuring device described in [15] above, communication reliability can be further improved. This is because the CAN (Controller Area Network) specifies a communication data configuration in which bit errors and burst errors, if contained in communication data, can be detected and corrected.

### [16] <Control of shutting off of power to voltage measuring units effected via general transmission path>

A voltage measuring device includes plural voltage measuring units (2_1 to 2_m) corresponding to plural cell groups (B11 to B1n, B21 to B2n, - - - Bm1 to Bmn) making up an assembled battery by being series-coupled in multiple stages and a battery system control unit (1) coupled to the voltage measuring units via a transmission path (9).

The voltage measuring units each include an analog front end unit (4) which measures the voltage of each cell included in a corresponding one of the cell groups, an interface unit (6) which transmits a measurement result outputted from the analog front end unit to the transmission path, and a voltage measurement control unit (5) which controls the analog front end unit and the interface unit. The voltage measuring units each further include an insulating element (8) which allows communication between the voltage measurement control unit and the interface unit in a state of being electrically insulated from each other and a regulator (7) which stabilizes power supplied from a corresponding one of the cell groups and supplies the power to the voltage measurement control unit.

The regulator has a control function for stopping and starting power supply to the voltage measurement control unit based on a control command issued from the battery system control unit via the transmission path.

In the voltage measuring device described in [16] above, supplying and shutting off of power to the voltage measuring units (2_1 to 2_m) can also be controlled using control commands transmitted by the battery system control unit (1) via a transmission path other than the common bus. This makes it possible to reduce the power consumption of the battery system control unit (1).

### [17] <Control of shutting off of power to voltage measuring unit effected via general transmission path>

In the voltage measuring device described in [16] above, the voltage measurement control unit causes power supply thereto to be stopped based on the control command.

The voltage measuring units each further include a power restoration control circuit (41), an inductively coupled insulating element (46), and a peak detection circuit (47). The power restoration control circuit starts outputting a first AC signal based on the control command. The inductively coupled insulating element converts the first AC signal in a state of being insulated DC-wise into a second AC signal and transmits the second AC signal to the peak detection circuit. The peak detection circuit causes power supply to the voltage measurement control unit to be started using a signal generated by rectifying and smoothing the second AC signal.

In the voltage measuring device described in [17] above, it is possible also by using a control command transmitted via a transmission path other than the common bus to restore power supply to the battery side the power supply to which has been shut off.

### 2. Details of Embodiments

Before detailing embodiments of the present invention, preparatory study made by the inventors and problems found through the study will be described below.

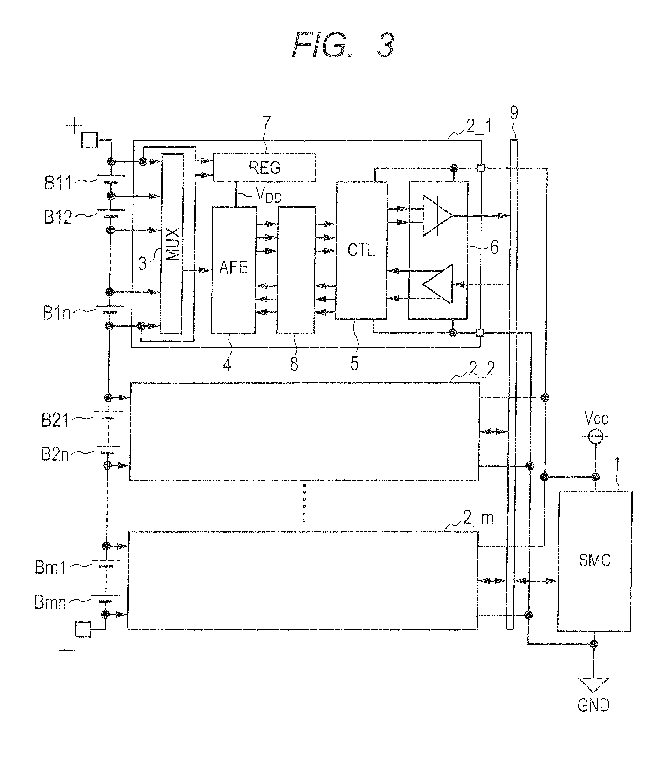

FIG. 3 is a block diagram of an assembled-battery voltage measuring device according to an embodiment of means for solving problems.

In the assembled-battery voltage measuring device, an assembled battery is comprised of plural series-coupled cells B11 to Bmn, and the voltage of each of the cells B11 to Bmn of the assembled battery is measured for monitoring and control by a battery system control unit 1. The assembled battery includes as many as m cell groups with each cell group having as many as n series-coupled cells. The m cell groups are provided with voltage measuring units 2_1 to 2_m. The voltage measuring units 2_1 to 2_m are respectively coupled to the battery system control unit 1 not on a one-to-one basis but collectively via a common bus 9.

Each of the voltage measuring units 2_1 to 2_m includes a multiplexer 3, an analog front end 4, a voltage measurement control unit 5, an interface unit 6, a regulator 7, and an insulator circuit 8. The multiplexer 3 selects a cell to be measured out of the n cells and couples the selected cell to the analog front end unit 4. The analog front end unit 4 includes an analog/digital converter. Under control by the voltage measurement control unit 5, the analog front end unit 4 measures the voltage of the cell selected by the multiplexer 3 and outputs the voltage measurement after conversion into a digital value. The voltage measurement control unit 5 is, for example, a microcomputer (or a microcontroller) and, in communicating with the battery system control unit 1, controls communication based on the protocol of the common bus 9. When a control command from the battery system control unit 1 is received, the voltage measurement control unit 5 interprets the control command and, by controlling the multiplexer 3 and the analog front end unit 4, collects battery voltage measurement. The voltage measurement control unit 5 transmits the collected measurement to the battery system control unit 1. The insulator circuit 8 includes an insulating element, a drive circuit to drive the insulating element, and a detection circuit. The insulating element may be, for example, a photocoupler, an inductively coupled insulating element, or a capacitively coupled insulating element.

The interface unit 6 is a bus transceiver which meets the physical and electrical standards for the common bus 9. According to related-art technology, the battery system control unit 1 and each of the voltage measuring units 2_1 to 2_m are coupled on a one-to-one basis via a communication path provided with an insulating element to enable communication in an electrically insulated state. When the communication path is to be replaced by a common bus, a problem is posed as to where to insert the insulating element. The common bus requires a state in which high impedance is outputted without the common bus being driven. Also, there are physical and electrical standards to be met by the common bus. Therefore, simply inserting an insulating element in the coupling part between the interface unit 6 and the common bus 9 cannot meet the physical and electrical standards for the common bus 9.

Hence the insulator circuit 8 is inserted between the analog front end unit 4 and the voltage measurement control unit 5. This makes it possible to dispose a bus transceiver which meets the physical and electrical standards for the common bus 9 between the voltage measurement control unit 5 and the common bus 9 as the interface unit 6. With the plural voltage measuring units 2 and the battery system control unit 1 coupled via the common bus 9, the battery system control unit 1 requires no communication port other than that for interfacing with the common bus 9 and, also, no communication wire harness is required other than the common bus 9. This keeps the system cost low.

Inserting the insulator circuit 8 between the analog front end unit 4 and the voltage measurement control unit 5, however, poses a problem that a large number of insulating elements are required. Normally, an analog/digital converter provides a multiple bit parallel output, so that at least as many insulating elements as the number of bits of the analog/digital converter are required. Also, when a larger potential difference is involved, a larger number of insulating elements are required. Hence, it is necessary to use a large substrate area for mounting many insulating elements and external peripheral parts required for converter operation while adequately spacing them apart so as to secure electric insulation between the low voltage side and the high voltage side. Doing this requires a large cost and increases the system cost.

Furthermore, in order to realize a configuration in which the insulator circuit 8 is inserted between the analog front end unit 4 and the voltage measurement control unit 5, the voltage measurement control unit 5 also requires to be supplied with VCC, a low-voltage power supply for electrical system with which the battery system control unit 1 is also supplied. There are cases in which an assembled battery made up of cells series-coupled in multiple stages outputs a high voltage of up to several hundred volts. Referring to the assembled-battery voltage measuring device shown in FIG. 3, the voltage measuring unit 2_1 is coupled to the highest-potential cell group B11 to B1n, so that the ground level of the analog front end unit 4 is of a high potential. The cell group B11 to B1n comprised of as many as n series-coupled cells outputs several tens of volts. The voltage measuring units 2_1 to 2_m are each provided with a regulator 7 which generates power supply VDD by stepping down several tens of volts and supplies VDD to the analog front end unit 4.

According to related art technology, VDD is supplied to the analog front end unit 4 and the voltage measurement control unit 5. In the battery monitoring modules described in Japanese Unexamined Patent Publication Nos. Hei 11 (1999) - 196537, 2003-70179, and 2008-131670, a circuit (for example, a microcomputer) which corresponds to the above voltage measurement control unit 5 communicates with a cell voltage measuring circuit and controls cell voltage measurement. This circuit corresponding to the above voltage measurement control unit 5 has power used to perform operation supplied from the cells that are its target of voltage measurement. Referring to FIG. 3 of Japanese Unexamined Patent Publication No. 2003-70179, the power supply circuit 2 generates power supply VDD by stabilizing the power supplied from plural cells making up a part of the assembled battery. Referring to FIG. 3 of Japanese Unexamined Patent Publication No. 2008-131670, the power supplied from plural cells making up a part of the assembled battery is directly supplied as VCC without using any power supply circuit. Though no circuit is denoted as a power supply circuit, the power needed by the circuit on the battery side that is insulated using insulating elements is apparently provided by the battery.

According to related-art technology, power supply VDD is supplied from the battery side to the voltage measurement control unit 5. It may appear that changing this configuration so as to supply power VCC for electrical system from the battery system control system 1 side to the voltage measurement control unit 5 does not cause any problem.

As a result of careful study conducted by the inventors by also taking into consideration other specifications to be met by an assembled-battery voltage measuring device, however, it has been found out that such a configuration change generates a new problem. Namely, when a change is made so that, without supplying power supply VDD of the battery to the voltage measurement control unit5, power VCC for electrical system is supplied from the battery system control unit 1 side to the voltage measurement control unit 5, it becomes impracticable to reduce power consumption by temporarily stopping power supply to a part of the internal circuit of the voltage measuring unit 2.

There are cases in which an automobile is kept in storage for a long period of time, for example, up to several months, before being delivered to a purchaser. Also, when many automobiles are to be transported over a long distance, the means of transportation may be limited to ships because of the weights of the automobiles. This causes the automobiles to be kept mostly unused during transit. There are also cases in which an automobile is kept in storage by a user for an extended period of time for any reason on the part of the user (for example, when the user is on a business trip or is hospitalized for a long period of time). In such cases, a low-risk lead battery of a low-voltage may be unplugged by any person, e.g. the user or a worker, to stop battery power consumption, or the battery can easily be charged using an external charger before the battery is put in use again. In the case of a high-voltage assembled battery, however, charging it requires the use of a special charger. Even during a period in which a battery is not used, to monitor the condition of the battery, it is necessary to make the voltage measuring device periodically operate to transmit data on the battery to the battery system control unit. This is because it is necessary to keep monitoring, at least externally, the battery so as to detect abnormal condition (for example, heat generation caused by a foreign obj ect or over-discharge) of the battery if any develops. Even while the battery is not in use, its power is consumed. Hence, there is need to reduce battery power consumption as much as possible while the battery is not in use. During periods in which a battery is in normal use, in order to increase the mileage of the automobile, it is necessary to minimize power consumption of the voltage measuring unit.

In the battery monitoring modules described in Japanese Unexamined Patent PublicationNos. Hei 11 (1999) -196537, 2003 - 70179, and 2008-131670, for example, power supply VDD is supplied from the battery side to the analog front end units and voltage measurement control units. It is therefore possible to stop power supply to the plural voltage measuring units individually when the power is not required by them. In the assembled-battery voltage measuring device shown in FIG. 3, whereas it is possible to stop power supply to the analog front end units 4 individually, power supply to the voltage measurement control units 5 cannot be stopped individually with the plural voltage measuring units 2_1 to 2_m being collectively supplied with power. To stop power supply to the plural voltage measuring units individually requires a new control means.

As described above, it has been found necessary to provide a voltage measuring device which allows decreasing the system cost by reducing the wire harness used as communication paths between the plural voltage measuring units and the battery system control unit and in which power consumption of the voltage measuring units can be reduced.

### First Embodiment <Common Bus>

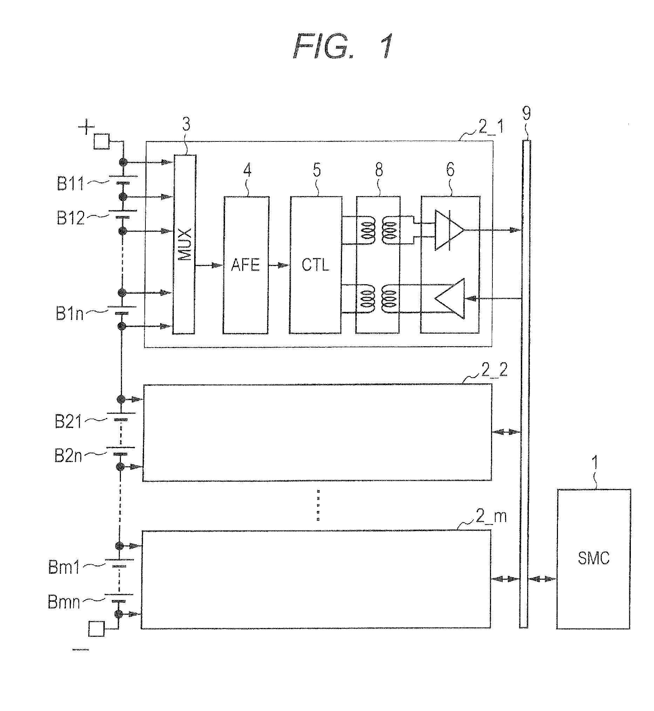

FIG. 1 is a block diagram of an assembled-battery voltage measuring device according to a first embodiment of the present invention.

In the assembled-battery voltage measuring device, an assembled battery is comprised of plural series-coupled cells B11 to Bmn, and the voltage of each of the cells B11 to Bmn of the assembled battery is measured for monitoring and control by a battery system control unit 1. The assembled battery includes as many as m cell groups with each cell group having as many as n series-coupled cells. The m cell groups are provided with voltage measuring units 2_1 to 2_m. The voltage measuring units 2_1 to 2_m are respectively coupled to the battery system control unit 1 not on a one-to-one basis but collectively via a common bus 9.

Each of the voltage measuring units 2_1 to 2_m (hereinafter may also be referred to collectively as "voltage measuring units 2" or individually as a "voltage measuring unit 2") includes a multiplexer 3, an analog front end 4, a voltage measurement control unit 5, an interface unit 6, and an insulator circuit 8. The multiplexer 3 selects a cell to be measured out of the n cells and couples the selected cell to the analog front end unit 4. The analog front end unit 4 includes an analog/digital converter. Under control by the voltage measurement control unit 5, the analog front end unit 4 measures the voltage of the cell selected by the multiplexer 3 and outputs the voltage measurement after conversion into a digital value. The voltage measurement control unit 5 is, for example, a microcomputer and, based on the protocol of the common bus 9, controls communication with the battery system control unit 1. In performing communication control, the voltage measurement control unit 5 interprets a control command received from the battery system control unit 1, collects cell voltage measurement by controlling the multiplexer 3 and the analog front end unit 4, and transmits the collected voltage measurement to the battery system control unit 1. The insulator circuit 8 includes an insulating element, a drive circuit to drive the insulating element, and a detection circuit. The insulating element may be, for example, a photocoupler, an inductively coupled insulating element, or a capacitively coupled insulating element.

The interface unit 6 is a bus transceiver which meets the physical and electrical standards for the common bus 9. In the foregoing assembled-battery voltage measuring device according to related-art technology, the battery system control unit 1 and each of the voltage measuring units 2_1 to 2_m are coupled on a one-to-one basis via a communication path provided with an insulating element to enable communication in an electrically insulated state. As already studied, simply replacing the individual communication paths with a common bus does not result in meeting the standard for the common bus 9. In the present embodiment, therefore, the insulator circuit 8 is inserted between the interface unit 6 and the voltage measurement control unit 5. This allows the interface unit 6 to be used as a bus transceiver meeting the physical and electrical standards for the common bus 9. With the plural voltage measuring units 2 and the battery system control unit 1 coupled via the common bus 9, the battery system control unit 1 requires no communication port other than that for interfacing with the common bus 9 and, also, no communication wire harness is required other than the common bus 9. This keeps the system cost low.

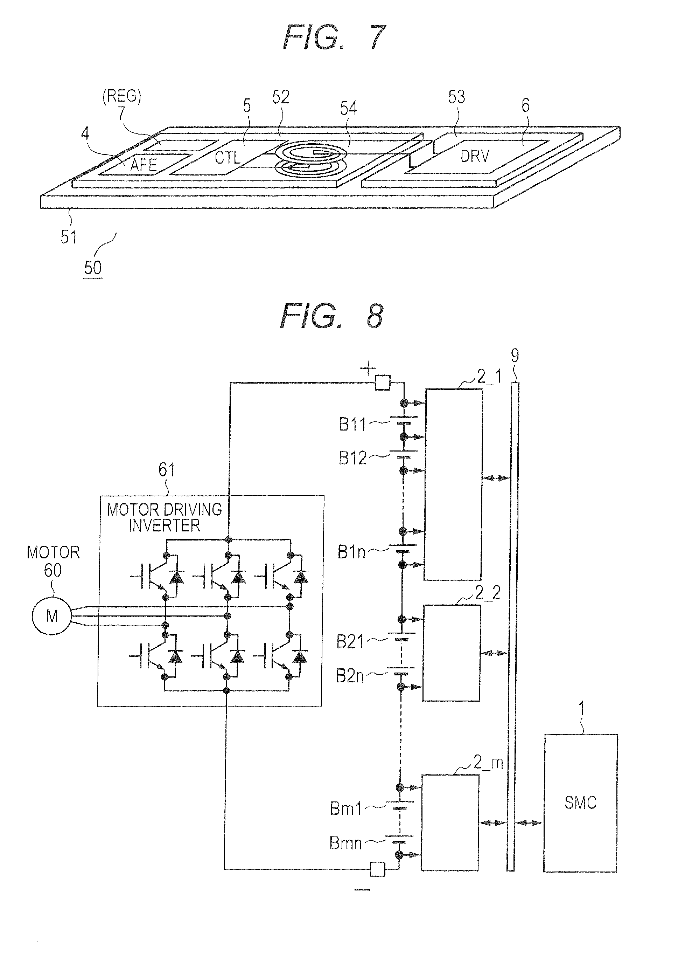

FIG. 8 is a block diagram showing an application of a voltage measuring device. A motor 60 and a motor driving inverter 61 are coupled to an assembled battery which supplies power to them. The voltage of each of the cells B11 to Bmn of the assembled battery is measured for monitoring by a battery system control unit 1. Voltage measuring units 2_1 to 2_m which measure the voltages of the grouped cells B11 to B1n, B21 to B2n, - - - Bm1 to Bmn are disposed near the grouped cells. In the case of an automobile, the grouped cells B11 to B1n, B21 to B2n, - - -, Bm1 to Bmn are widely disposed, for example, under seats. If, in such a case, the cell groups are coupled to the battery system control unit 1 on a one-to-one basis, wiring totaling up to several meters in length may be required. Using a common bus in such a case makes it possible to traversely wire all the grouped cells B11 to B1n, B21 to B2n, - - -, Bm1 to Bmn so as to form a continuous wiring path. This can reduce the total length of wiring to one half or shorter.

According to the first embodiment, both the analog front end unit 4 and the voltage measurement control unit 5 are, as shown in FIG. 1, disposed in a same power supply system to be on the cell side as seen from the insulator circuit 8. This makes it possible to reduce power consumption in various ways. The power consumption of the assembled battery can be reduced, for example, by adopting some or all of the following methods.
-- Stop operations of the analog front end unit 4, voltage measurement control unit 5 and insulator circuit 8 during periods in which no communication is performed under control by the battery system control unit 1. This can reduce the power consumption of the analog front end unit 4 and voltage measurement control unit 5. Furthermore, it is also made possible to reduce the standby current of the insulator circuit 8, for example, the bias current or idling current of a differential circuit and also, in cases where a photocouplers is used as an insulating element, the dark current of the photocoupler.
- - When, in a state in which a control command to be inputted from the battery system control unit 1 is being awaited, stop operations and bias supply on the transmitting side of the insulator circuit 8 and interface unit 6. Conversely, when in a transmitting state, stop operations and bias supply on the receiving side of the insulator circuit 8 and interface unit 6.
- - Use a microcomputer as the voltage measurement control unit 5 and, using a timer, make the analog front end unit 4 periodically measure cell voltages and, when cell voltage measurement is not performed, stop power supply to the analog front end unit 4. When the analog front end unit 4 is engaged in cell voltage measurement, put the microcomputer used as the voltage measurement control unit 5 in sleep mode or standby mode. When the voltage measurement control unit 5 is temporarily stopped, stop power supply to the circuit driving the insulator circuit 8.
-- Depending on the communication speed setting, appropriately adjust the bias current or switch to a circuit adjusted for low-speed communication.

### Second Embodiment <Regulator>

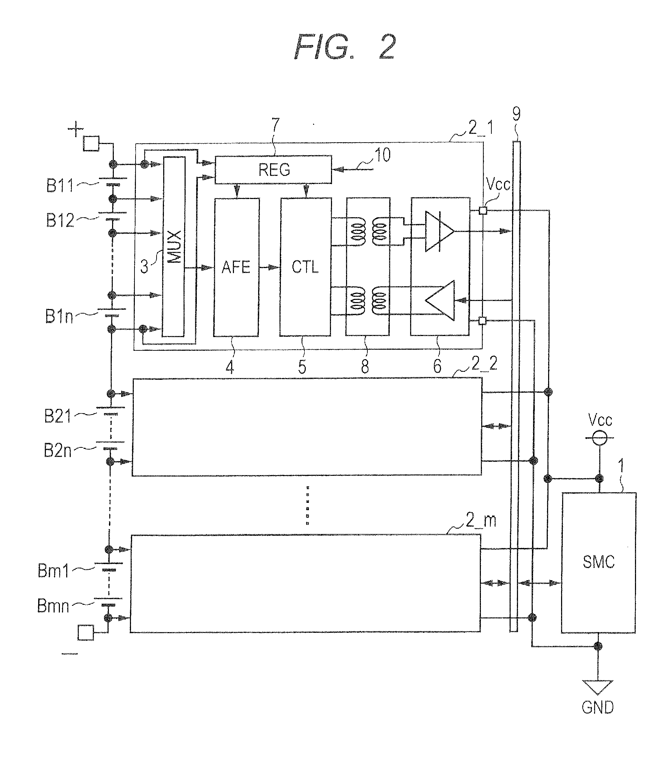

FIG. 2 is a block diagram of an assembled-battery voltage measuring device according to a second embodiment of the present invention.

In the assembled-battery voltage measuring device of the second embodiment, as in the assembled-battery voltage measuring device of the first embodiment, an assembled battery is comprised of plural series-coupled cells B11 to Bmn, and the voltage of each of the cells B11 to Bmn is measured for monitoring and control by a battery system control unit 1. The assembled-battery voltage measuring device of the second embodiment differs from the assembled-battery voltage measuring device of the first embodiment in that the voltage measuring unit 2_1 is provided with a regulator 7. The regulator 7 steps down the voltage of tens of volts generated by the group of n series-coupled cells B1a to B1n and supplies the stepped-down voltage as power supply VDD to the analog front end unit 4 and the voltage measurement control unit 5. The other voltage measuring units 2_2 to 2_m are also configured identically to the voltage measuring unit 2_1.

The number of cells (battery cells) series-coupled in an assembled battery is dependent on, for example, output voltage specification, so that the number of series-coupled cells is not necessarily divisible by the number of voltage measuring units 2. Namely, the voltage generated by the cells series-coupled in a cell group may differ between voltage measuring units. Also, the voltage largely varies with load and, when the load is inductive like a motor, the load may largely vary with a counter-electromotive force. Other noises may also cause the potential to vary between points along series-coupled cells.

According to the second embodiment, the regulator 7 stabilizes the voltage generated by the cells series-coupled in each cell group, generates the power supply VDD and supplies it to the analog front end unit 4 and the voltage measurement control unit 5. This makes it possible to measure cell voltages without being affected by noises such as battery load variations.

It is possible to input a power supply control signal 10 to the regulator 10 and control power supply to the analog front end unit 4, voltage measurement control unit 5 and insulator circuit 8 either individually or collectively. When controlling power supply to them individually, careful power supply control allows power consumption to be effectively reduced, for example, by stopping power supply to the voltage measurement control unit 5 and the insulator circuit 8 while the analog front end unit 4 is engaged in cell voltage measurement or by stopping power supply to the analog front end unit 5 while communication is being performed. When stopping total power supply, stopping the power supply stabilization operation of the regulator 7 further reduces power consumption.

The power supply control signal 10 is controlled based on command signals transmitted by the battery system control unit 1. The battery system control unit 1 transmits control commands to the voltage measuring units 2_1 to 2_m via the common bus 9. In each of the voltage measuring units 2_1 to 2_m, the voltage measurement control unit 5 interprets a control command received from the battery system control unit 1 and generates a power supply control signal 10. The power supply control signal 10 is outputted from a circuit which can maintain an appropriate potential level even when the power supply to the voltage measurement control unit 5 is shut off. The circuit is, for example, a battery-powered register circuit or a set/reset flip-flop circuit. A value for shutting off the power supply to the voltage measurement control unit 5 can be set in such a circuit by the voltage measurement control unit 5 itself. A value for restoring the power supply to the voltage measurement control unit 5, however, cannot be set in the circuit by the voltage measurement control unit 5 supplied with no power. To allow the power supply to the voltage measurement control unit 5 to be restored, another circuit is provided which interprets a control command transmitted from the battery system control unit 1 and received by the interface unit 6 via the common bus 9 and which, based on the control command, sets a value for restoring the power supply to the voltage measurement control unit 5 in the above-described circuit. A concrete example of this operation will be described in detail later in connection with a subsequent embodiment.

As described above, supplying the voltage measuring units 2_1 to 2_m with power and shutting off the power supply can be controlled in accordance with control commands received from the battery system control unit 1 via the common bus 9. Thus, using a common bus as described above makes it possible to reduce the wire harnesses to be used so as to eventually reduce the system cost and power consumption.

### Third Embodiment <Differential Bus and CAN (Controller Area Network)>

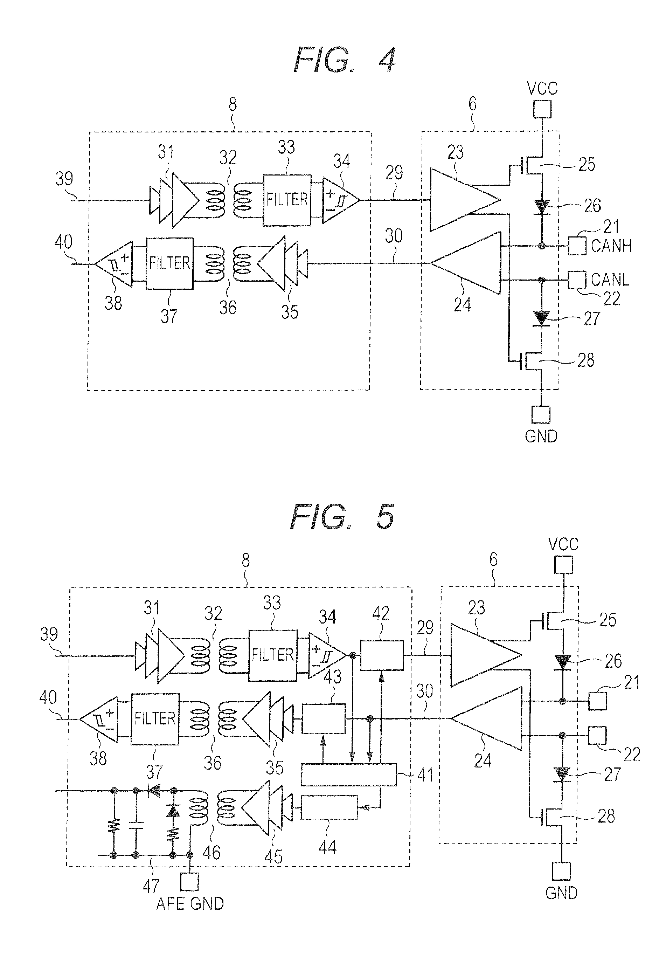

FIG. 4 is a block diagram showing an embodiment of the interface unit 6 and insulator circuit 8.

In a third embodiment, when the common bus 9 is a differential bus, the interface unit 6 drives the differential bus and receives signals coming via the differential bus. In the third embodiment, the signals received via the differential bus are assumed to be CANH 21 on the positive side and CANL 22 on the negative side.

The interface unit 6 is a well-known CAN transceiver. It includes a reception circuit 24 to receive, as differential input, the positive CANH 21 and the negative CANL 22, an upper arm transistor 25 to drive the positive CANH 21, and a lower arm transistor 28 to drive the negative CANL 22. Diodes 26 and 27 are provided for back-current prevention. The transistors 25 and 28 are both driven by a transmission circuit 23. When the transistors 25 and 28 are both turned off, the impedance of the output from the interface unit 6 to the common bus 9 becomes high, so that the transceiver of another interface unit is allowed to drive the common bus 9.

Serial transmit data outputted from the voltage measurement control unit 5 is inputted to a transmit data input 39 on the high potential side. The inputted serial transmit data is amplified at an amplifier 31 and is then inputted to an insulating element 32. The insulating element 32 denoted in FIG. 4 represents, as an example, a transformer which is an inductively coupled insulating element. The transformer with its primary side and secondary side DC-electrically isolated from each other passes AC signals. The serial transmit data outputted from the secondary side of the transformer passes through a filter 33 and a waveform shaping circuit 34 to be shaped into a pulse waveform and is then inputted as transmit data 29 on the low potential side to the transmission circuit 23 included in the interface unit 6.

Receive data 30 on the low potential side which is outputted from the reception circuit 24 included in the interface unit 6 is inputted to the primary side of an insulating element 36 at an amplifier 35 to be then transferred to the secondary side. Subsequently, the receive data 30 is shaped into a pulse waveform by passing through a filter 37 and a waveform shaping circuit 38 and is then inputted as serial receive data to the voltage measurement control unit 5.

In each of the transformers, i.e. the inductively coupled insulating elements 32 and 36, the primary-side potential is high depending on the location of the cells to which the voltage measuring unit 2 is coupled, but the potential level of the secondary-side that is in the electrical system also including the battery system control unit 1 is low. Hence, the circuits closer to the common bus 9 than the inductively coupled insulating elements 32 and 36 are supplied with power supply VCC and GND supplied to the electrical system that includes the battery system control unit 1.

Using a differential bus, CAN in particular, as the common bus 9 generates the following effects.

Even when there is a large potential difference between two voltage measuring points, related communication input/output signals can be made the same as the battery system control unit in potential level, so that voltage communication is enabled without using current to represent information.

Using a differential bus enhances noise immunity of the common bus.

Using a CAN (Controller Area Network) in which bit errors and burst errors, if contained in communication data, can be detected and corrected improves communication reliability.

However, it is not necessary to stick to the CAN as long as the communication system to be used can improve communication reliability by means similar to those described above. For example, a FlexRay system which is capable of high-speed data transmission while being more complicated than the CAN may be used. With the system configuration not required to allow media access under multi-master control, cost reduction by adopting master/slave control is possible.

Though the example circuit shown in FIG. 4 includes transformers made up of inductively coupled insulating elements used as the insulating elements 32 and 36, the insulating elements 32 and 36 may also be capacitively coupled insulating elements or photocouplers.

### Fourth Embodiment <Power Restoration>

With the battery side and the bus side of each voltage measuring unit 2 insulated from each other by the insulator circuit 8, the power supply to the analog front end unit 4 and the voltage measurement control unit 5 on the battery side may be shut off to reduce power consumption. In that case, however, it is necessary to consider how to restore the power supply. Even when a control command for restoring the power supply to the analog front end unit 4 and the voltage measuring control unit 5 is received by the interface unit 6 via the common bus 9, the circuit to perform control responding to such a control command cannot operate as it is, being on the battery side, supplied with no power. A circuit and a control sequence which can be used to solve this problem will be described below.

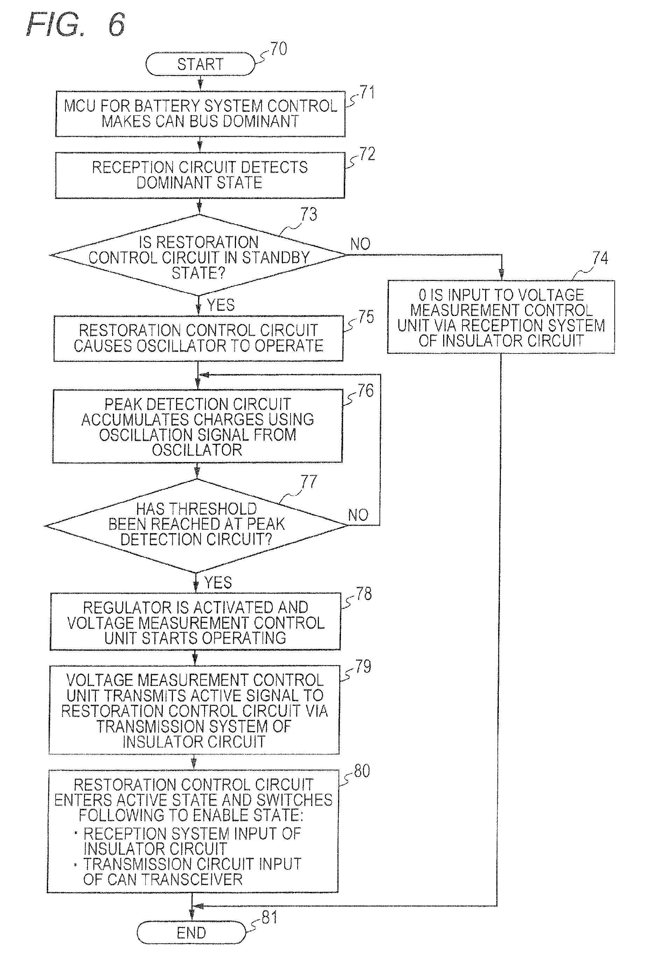

FIG. 5 is a block diagram showing an embodiment of the interface unit 6 and the insulator circuit 8 that can restore, responding to a control command received via the common bus, the power supply to the battery side of the voltage measuring unit 2. FIG. 6 is a flowchart of a control sequence for restoring the power supply.

Compared with the insulator circuit 8 shown in FIG. 4, the insulator circuit 8 shown in FIG. 5 additionally includes an insulating element 46, a circuit for detecting, on the bus side, a control command for power supply restoration, and a circuit for transferring a result of detection of such a control command to the battery side via the insulating element 46. The transmission system and reception system of the insulator circuit 8 are provided with enable logic circuits 42 and 43, respectively. A restoration control circuit 41 included in the insulator circuit 8 detects a control command, for restoring the power supply to the battery side, from the reception circuit 24 of the interface unit 6 and outputs the detection result to an oscillator 44. Responding to the detection signal received from the restoration control circuit 41, the oscillator 44 starts oscillation causing an oscillation signal to be transmitted to the battery side via an amplifier 45 and the insulating element 46. With the secondary side of the insulating element 46 coupled to a peak detection circuit 47, the oscillation signal received is converted into a DC current by undergoing detection and smoothing processing thereby causing control for restoring the power supply to the cell side to be started, for example, by activating the regulator. A signal indicating the restoration of the power supply to the battery side is fed back from the transmit data input 39 on the high potential side to the restoration control 41 via the insulating element 32. Based on the signal received, the restoration control circuit 41 puts both the enable logic circuit 42 in the transmission system and the enable logic circuit 43 in the reception system into an enable state.

Since, when the battery side is partly supplied with power, it is possible to operate a circuit for shaping the signal using an inductively coupled insulating element, control for restoring the battery side power supply can be started using a filter 37 and a waveform shaping circuit 38 similar to those used in the reception system. Furthermore, a photocoupler may be used as the insulating element 46. When the battery side is supplied with no power at all, the filter 37 and the waveform shaping circuit 38 configured as active circuit elements are not operable. The photocoupler cannot be used, either. This is because signal amplification is not performable with no power supplied.

As described in connection with the present embodiment, it is possible to generate a control signal on the side the power supply to which has been shut off. This can be done by: adopting an inductively coupled insulating element (transformer) as the insulating element 46; using an AC signal (oscillation signal), not a single-pulse signal, as an information transmitting signal; and detecting and smoothing the AC signal on the secondary side of the inductively coupled insulating element supplied with no power.

Such a control signal need not necessarily be used for control purposes. For example, it may be used as a power supply for operating a circuit. Or, without using a peak detection circuit, the control signal may be used as an AC signal to serve as a clock for a switched capacitor. When the control signal is used only to restore power supply, the operation of the oscillator 44 may be stopped by detecting restoration of the power supply and, for example, using the same signal as used to enable the enable logic circuits 42 and 43.

Even though the above configuration includes the oscillator 44 used to generate an AC signal (oscillation signal), in cases where an AC signal such as a clock signal is already supplied to the restoration control circuit, the AC signal may be transmitted to the inductively coupled insulating element (transformer) 46. In such cases, the oscillator 44 is not required.

A power restoration sequence will be described below with reference to FIG. 6.

The battery system control unit 1 makes the CAN bus that is the common bus 9 dominant (step 71). When the bus is made dominant, the bus is used for preferential output based on the CAN standard. When the reception circuit 24 detects the dominant state of the common bus 9 (step 72), whether or not the restoration control circuit 41 is in a standby state is determined (step 73). When the restoration control circuit 41 is not in a standby state, 0 is inputted to the voltage measurement control unit 5 via the reception system of the insulator circuit 8 to end processing (step 74). When the restoration control circuit 41 is in a standby state, that is, when a state with the power supply to the battery side shut off is held in the restoration control circuit 41, processing advances to steps 75 to 78 for power restoration.

First, the restoration control circuit 41 causes the oscillator 44 to operate (step 75). The oscillation signal is inputted to the peak detection circuit 47 via the amplifier 45 and the transformer used as the insulating element 46. The oscillation signal generated by the oscillator 44 causes the peak detection circuit 47 to accumulates charges (step 76). When the charges accumulated in the peak detection circuit 47 reaches a predetermined threshold (step 77), the regulator 7 is activated. As a result, the power supply to the voltage measurement control unit 5 is restored and the voltage measurement control unit 5 starts operating (step 78).

The voltage measurement control unit 5 that has resumed operation transmits an Active signal to the restoration control circuit 41 via the transmission system of the insulator circuit 8 (step 79). The restoration control circuit 41 enters an active state and switches the enable logic circuit 43 included in the reception system of the insulator circuit 8 to an enable state and also switches the enable logic circuit 42 included in the transmission system of the insulator circuit 8 coupled to the CAN transceiver to an enable state (step 80).

In this way, the power supply to the battery side of each voltage measuring unit 2 can be restored using a control command complying with the CAN standard.

By way of the second and third embodiments, a voltage measuring device in which shutting off and restoration of power supply to each of voltage measuring units 2_1 to 2_m are controlled using a control command transmitted from the battery system control unit 1 via the common bus 9 has been described. The method used to control shutting off and restoration of the power supply is not limited by the format of communication between the battery system control unit 1 and the voltage measuring units 2_1 to 2_m. The control method is applicable also in cases where the battery system control unit 1 and the voltage measuring units 2_1 to 2_m are coupled on a one-to-one basis based on related-art technology.

### Fifth Embodiment <SiP (System in Package) and Micro-isolator>

FIG. 7 is a bird's-eye view of a voltage measuring unit mounted on a substrate according to a fifth embodiment of the present invention.

Referring to FIG. 7, a voltage measuring unit 2 includes two semiconductor integrated circuit devices 52 and 53 mounted on a substrate 51 using an SiP (System in Package) technique. An inductively coupled insulating element 54 (micro-isolator) is formed in the semiconductor integrated circuit device 52. The inductively coupled insulating element 54 is coupled to the voltage measurement control unit 5. The semiconductor integrated circuit device 52 also includes the analog front end unit 4 and the regulator 7 integrated therein. The semiconductor integrated circuit device 53 includes the interface unit 6. The inductively coupled insulating element 54 can be realized by forming, using a multi-layer wiring technique for semiconductor processing, two spirally wound coils in two wiring layers such that the two coils face each other across an insulating layer disposed between them. The coils thus arranged form a transformer and are inductively coupled AC-wise. Even though only one transformer is shown in FIG. 7, there may be more than one transformer. The amplifiers 31 and 35, filters 33 and 37, and waveform shaping circuits 34 and 38, not shown in FIG. 7, are included in the semiconductor integrated circuit 52 or 53.

The above configuration makes it possible to make components smaller for cost reduction and to reduce the substrate area required to mount the device.

Furthermore, forming the semiconductor integrated circuit devices 52 and 53 on a same SOI (Silicon On Insulator) substrate, that is, integrating all components on a single chip makes it possible to make components further smaller and to further reduce the substrate area required to mount the device.

The invention made by the present inventors has been described in detail based on embodiments, but the invention is not limited by the embodiments and can be varied in various ways without departing from the scope of the invention.

An exemplary voltage measuring device applied to an assembled battery comprised of cells (battery cells) series-coupled in multiple stages has been described. Cells can be effectively applied to a secondary battery such as a lithium-ion battery or a nickel-hydride battery for the purpose of monitoring the charged/discharged state of the battery. Also, cells can be effectively applied to a voltage measuring device for measuring the voltage of power supplies series-coupled in multiple stages, for example, the voltage of an assembled battery made up of series-coupled primary cells.

According to an exemplary embodiment, in an assembled battery including plural cells series-coupled in multiple stages, each voltage measuring unit includes an analog front end unit which measures the voltages of cells, an interface unit for interfacing with a common bus, a voltage measurement control unit which controls the analog front end unit and the interface unit, and an insulating element which allows communication between the voltage measurement control unit and the interface unit in a state of being insulated from each other. The interface unit of each voltage measuring unit is electrically insulated, so that it can be coupled to a low-voltage power supply system of the electrical system that includes the battery system control unit. Since there is no potential difference between the interface unit and the battery system control unit, they can be coupled to each other via the common bus.

## Claims

1. A semiconductor device for measuring a voltage of each of a plurality of cells which are series-coupled in multiple stages making up an assembled battery and for transmitting a measurement result to a battery system control unit via a common bus, the semiconductor device comprising:
an analog front end unit which measures the voltage of each of the cells;
a voltage measurement control unit which performs control to transmit a measurement result outputted from the analog front end unit to the common bus;
an interface unit which can make switching between driving the common bus and setting a coupling thereof with the common bus to high impedance; and
an insulating element which allows communication between the voltage measurement control unit and the interface unit in a state of being electrically insulated from each other.

2. The semiconductor device according to claim 1, further comprising a regulator which stabilizes power supplied from the cells and supplies the power to the voltage measurement control unit, the regulator having a power supply control signal for supplying and stopping the power to the voltage measurement control unit.

3. The semiconductor device according to claim 2, wherein the power supply control signal is controlled based on a receive signal outputted from the interface unit.

4. The semiconductor device according to claim 3, further comprising a power restoration control circuit, an inductively coupled insulating element and a peak detection circuit,
wherein the power restoration control circuit starts outputting a first AC signal based on the receive signal,
wherein the inductively coupled insulating element converts the first AC signal in a state of being insulated DC-wise into a second AC signal and transmits the second AC signal to the peak detection circuit, and
wherein the peak detection circuit controls the power supply control signal using the second AC signal after rectifying and smoothing the second AC signal.

5. The semiconductor device according to one of claims 1 to 4, further comprising a power supply terminal on a low voltage side for supplying power to the interface unit,
wherein the interface unit includes a differential drive circuit and a differential reception circuit, the differential drive circuit operating using power supplied from the power supply terminal on the low voltage side and either driving the common bus using a differential signal or outputting high impedance, the differential reception circuit operating using the power supplied from the power supply terminal on the low voltage side and receiving the differential signal from the common bus.

6. The semiconductor device according to claim 5,
wherein the differential drive circuit drives the common bus in a manner to meet a CAN standard, and
wherein the differential reception circuit receives a signal from the common bus meeting the CAN standard.

7. The semiconductor device according to one of claims 1 to 6, wherein the analog front end unit, the voltage measurement control unit, the interface unit, and the insulating element are integrated in a same package.

8. The semiconductor device according to claim 7, wherein the insulating element is a transformer formed over a semiconductor substrate with a primary side and a secondary side of the transformer insulated from each other across an insulating layer and with the voltage measurement control unit also formed over the semiconductor substrate.

9. The semiconductor device according to claim 7,
wherein the insulating element is a transformer formed over a semiconductor substrate with a primary side and a secondary side of the transformer insulated from each other across an insulating layer, and
wherein the voltage measurement control unit, the insulating element, and the interface unit are formed over a same SOI substrate, the voltage measurement control unit and the interface unit being formed over wells insulated from each other.

10. A voltage measuring device, comprising:
a plurality of voltage measuring units corresponding to a plurality of cell groups making up an assembled battery by being series-coupled in multiple stages;
a common bus intercoupling the voltage measuring units; and
a battery system control unit coupled to the common bus,
wherein the voltage measuring units each include:
an analog front end unit which measures the voltage of each cell included in a corresponding one of the cell groups;
a voltage measurement control unit which performs control to transmit a measurement result outputted from the analog front end unit to the common bus;
an interface unit which can make switching between driving the common bus and setting a coupling thereof with the common bus to high impedance; and
an insulating element which allows communication between the voltage measurement control unit and the interface unit in a state of being electrically insulated from each other.

11. The voltage measuring device according to claim 10, wherein the voltage measuring units each further include a regulator which stabilizes power supplied from a corresponding one of the cell groups and supplies the power to the voltage measurement control unit, the regulator supplying and stopping the power to the voltage measurement control unit according to a power supply control signal.

12. The voltage measuring device according to claim 11, wherein the voltage measuring units each control the power supply control signal according to a control command issued by the battery system control unit via the common bus.

13. The voltage measuring device according to claim 12,
wherein the voltage measurement control unit can output, based on the control command, a signal for stopping power supply to the voltage measurement control unit as the power supply control signal, and
wherein the voltage measuring units each further include a power restoration control circuit, an inductively coupled insulating element, and a peak detection circuit, the power restoration control circuit starting outputting a first AC signal based on the control command, the inductively coupled insulating element converting the first AC signal in a state of being insulated DC-wise into a second AC signal and transmitting the second AC signal to the peak detection circuit, the peak detection circuit being capable of outputting a signal generated by rectifying and smoothing the second AC signal as the power supply control signal for causing power supply to the voltage measurement control unit to be started.

14. The voltage measuring device according to one of claims 10 to 13,
wherein the voltage measuring units each further include a regulator which stabilizes power supplied from a corresponding one of the cell groups and supplies the power to the voltage measurement control unit, and
wherein the interface unit is supplied with constant-voltage power with which the battery system control unit is also supplied and includes a differential drive circuit and a differential reception circuit, the differential drive circuit operating using power supplied on the low voltage side and either driving the common bus using a differential signal or outputting high impedance, the differential reception circuit operating using power supplied on the low voltage side and receiving a differential signal from the common bus.

15. The voltage measuring device according to claim 14, wherein the network including the common bus meets a CAN standard.

16. A voltage measuring device, comprising:
a plurality of voltage measuring units corresponding to a plurality of cell groups making up an assembled battery by being series-coupled in multiple stages; and a battery system control unit coupled to the voltage measuring units via a transmission path,
wherein the voltage measuring units each include:
an analog front end unit which measures the voltage of each cell included in a corresponding one of the cell groups;
an interface unit which transmits a measurement result outputted from the analog front end unit to the transmission path,
a voltage measurement control unit which controls the analog front end unit and the interface unit,
an insulating element which allows communication between the voltage measurement control unit and the interface unit in a state of being electrically insulated from each other, and
a regulator which stabilizes power supplied from a corresponding one of the cell groups and supplies the power to the voltage measurement control unit,
wherein the regulator has a control function for stopping and starting power supply to the voltage measurement control unit based on a control command issued from the battery system control unit via the transmission path.

17. The voltage measuring device according to claim 16,
wherein the voltage measurement control unit causes power supply thereto to be stopped based on the control command, and
wherein the voltage measuring units each further include a power restoration control circuit, an inductively coupled insulating element, and a peak detection circuit, the power restoration control circuit starting outputting a first AC signal based on the control command, the inductively coupled insulating element converting the first AC signal in a state of being insulated DC-wise into a second AC signal and transmitting the second AC signal to the peak detection circuit, the peak detection circuit causing power supply to the voltage measurement control unit to be started using a signal generated by rectifying and smoothing the second AC signal.
